# EUROPÄISCHE PATENTANMELDUNG

(11) **EP 4 825 510 A1**
(43) Veröffentlichungstag der Anmeldung: **21.10.2026**
(21) Anmeldenummer: 25182472.8
(22) Anmeldetag: 12.06.2025
(51) Int. Cl.: B23B 31/20, F16B 13/00, B25B 13/48

(54) **BEDIENTEIL ZUR BETÄTIGUNG EINER SPANNMUTTER**

(30) Priorität: 14.04.2025 EP 25170323
(71) Anmelder: Zollmann GmbH, 72393 Burladingen (DE)
(72) Erfinder: Zollmann, Martin, 72393 Burladingen (DE)
(74) Vertreter: Jakelski & Althoff Patentanwälte PartG mbB

(57) **Zusammenfassung**

Es wird ein Bedienteil (100; 200; 400) zur Betätigung einer Spannmutter vorgeschlagen, wobei das Bedienteil (100; 200; 400) einen endständigen, ringförmigen Aufnahmebereich zum Greifen der Spannmutter aufweist. Der endständige, ringförmige Aufnahmebereich umfasst eine Mehrzahl von Nuten (101), die von außen nach innen verlaufen, und zwischen den Nuten liegenden Nasen (102). Die von den Nuten (101) begrenzten Seitenflanken der Nasen (102) sind jeweils mit einem hinterschnittenen Profil versehen. Der endständige, ringförmige Aufnahmebereich weist einen Zentrierrand (150; 250) auf, der die Ebene der Grundfläche der Nuten (101) überragt.

## Beschreibung

Die vorliegende Erfindung betrifft ein Bedienteil zur Betätigung einer Spannmutter gemäß dem Oberbegriff des Anspruchs 1. Weiterhin betrifft die Erfindung ein Spannsystem, das mindestens ein solches Bedienteil umfasst.

### Stand der Technik

Spannmuttern kommen beispielsweise zum Spannen von Spannzangen zum Einsatz, die zum Einspannen von Werkzeugschäften in der Werkzeugaufnahme einer Werkzeugmaschine verwendet werden. Insbesondere bei begrenztem Raum und engem Zugang zu der Spannmutter müssen besondere Vorkehrungen getroffen werden, damit der erforderliche Kraftaufwand zum Spannen ausgeübt wenden kann. Herkömmlicherweise erfolgt das Spannen mit Hilfe eines Schlüssels, der beispielsweise mit Stiften ausgestattet ist, die in lochförmige Vertiefungen der Spannmutter eingreifen, sodass mit Hilfe des Schlüssels die Spannmutter gespannt werden kann. Die deutsche Gebrauchsmusterschrift DE 296 08 677 U1 beschreibt beispielsweise eine Spannmutter mit langlochförmigen Vertiefungen zum Eingriff der Stifte eines Schlüssels.

Um zu vermeiden, dass der Schlüssel abrutschen kann, beschreibt die europäische Patentanmeldung EP 1 052 047 A2 eine Spannmutter, die nutenförmige Vertiefungen zum Eingriff der an einem Spannschlüssel angeordneten Stifte vorsieht. Die Nuten sind mit einem schwalbenschwanzförmigen Querschnitt ausgebildet, sodass ein Abrutschen des Schlüssels durch das Hintergreifen der Stifte des Schlüssels, die ein komplementäres Profil aufweisen, in dem Hinterschnitt der Nuten vermieden wird.

Die deutsche Gebrauchsmusterschrift DE 201 19 008 U1 schlägt ebenfalls ein Spannsystem vor, bei dem die auf der Stirnseite der Spannmutter angeordneten Nuten einen schwalbenschwanzförmigen Querschnitt aufweisen. Die inneren Kanten der Nuten verlaufen in radialer Richtung, sodass sich die Nuten zur Mitte der Spannmutter hin gleichmäßig verjüngen. Das System umfasst weiterhin einen Schlüssel mit einem Schlüsselkopf, der entsprechend ausgebildete Nasen zum Eingriff in die Nuten der Spannmutter aufweist. Mit diesem System soll ein Abkippen und Herausgleiten des Schlüssels und eine damit verbundene Bruch- und Abrutschgefahr bei der Betätigung der Spannmutter vermieden werden.

Auch andere Formen des Hinterschnitts bei vergleichbaren Spannmuttern sind bereits beschrieben. So offenbart die deutsche Offenlegungsschrift DE 103 02 529 A1 eine vergleichbare Spannmutter, bei der die Nuten ein S-förmiges Profil als Hinterschnitt aufweisen. Durch das hinterschnittene Profil der Nuten kann zwar eine gewisse Stabilisierung der Mutter am Schlüssel erreicht werden, allerdings kann dennoch ein seitliches Herausrutschen der Mutter aus dem Schlüssel nicht vollständig verhindert werden.

Die deutsche Patentanmeldung DE 10 2009 006 520 A1 beschreibt ein Spannsystem mit einer Spannmutter und einem Schlüssel, wobei die Spannmutter an ihrer Stirnseite Aussparungen aufweist, die zur Aufnahme von Vorsprüngen des Schlüssels vorgesehen sind. Die Aussparungen sind entweder am Außenrand oder am Innenrand der Spannmutter angeordnet, wobei der jeweils gegenüberliegende Rand, also der Innenrand oder der Außenrand, geschlossen ist. Hierdurch können die Vorsprünge des Schlüssels entweder von außen oder von innen angreifen und in die Aussparungen der Spannmutter eingeführt werden. Die Aussparungen der Spannmutter sind mit wenigstens einem Hinterschnitt zum Hintergreifen bzw. Untergreifen durch die Vorsprünge des Schlüssels versehen. Dies gewährleistet ein verrutschungsfreies Eingreifen des Schlüssels. Insbesondere kann durch den Hinterschnitt die Spannmutter nicht aus dem Schlüssel herausfallen.

Neben einem herkömmlichen Schlüssel mit einer länglichen Grundform und einem Schlüsselkopf, der mit entsprechenden Geometrien für einen Eingriff in die Strukturen der Spannmutter ausgestattet ist, können auch andere Schlüsselformen bzw. allgemein andere Bedienteile zum Spannen und Lösen derartiger Spannmuttern zum Einsatz kommen. In diesem Zusammenhang spielen vor allem Stecknüsse, insbesondere Drehmomentstecknüsse, eine wichtige Rolle.

Eine Stecknuss beschreibt im Allgemeinen ein Werkzeugteil, das eine Verbindung zwischen einem Schlüssel, beispielsweise einem Ratschenschlüssel, und der jeweiligen Mutter, Schraube oder anderem Schraubverbindungselement herstellt. Auf der einen Seite der Stecknuss ist eine Aufnahme zur Verbindung mit dem Schlüssel, beispielsweise ein Außensechskant oder ein Innenvierkant, ausgebildet. Auf der anderen Seite der Stecknuss ist eine Geometrie vorgesehen, die an die Form der zu greifenden Mutter, Schraube oder anderem Schraubverbindungselement angepasst ist.

Auch die oben bereits erwähnte DE 10 2009 006 520 A1 offenbart eine Stecknuss mit einem Außensechskant an einem Ende. An dem anderen Ende sind die erwähnten Vorsprünge ausgebildet, die zum Eingriff in die entsprechend ausgebildeten Aussparungen der Spannmutter vorgesehen sind.

Ein anderes, häufig hilfreiches Bedienteil für Spannmuttern ist die sogenannte Eindrehhilfe, die ebenfalls mit beispielsweise einem Außensechskant und auf der anderen Seite mit einer Geometrie zum Greifen der Spannmutter ausgebildet ist. Im Vergleich mit der Stecknuss ist eine Eindrehhilfe im Allgemeinen kürzer ausgebildet.

Das beschriebene System der DE 10 2009 006 520 A1 stellt für viele Anwendungen eine befriedende Lösung bereit, die ein anwenderfreundliches und sicheres Betätigen eines Spannsystems erlaubt. Allerdings besteht immer wieder das Bedürfnis nach alternativen Systemen.

Vor diesem Hintergrund stellt sich die Erfindung die Aufgabe, ein Bedienteil zum Arbeiten mit einer Spannmutter zur Verfügung zu stellen. Das Bedienteil soll einfach aufgebaut sein und dennoch ein verrutschungsfreies und sicheres Einsetzen und Spannen einer Spannmutter mit minimalem Kraftaufwand ermöglichen.

### Offenbarung der Erfindung

Diese Aufgabe wird durch ein Bedienteil zur Betätigung einer Spannmutter gelöst, wie es in Anspruch 1 beschrieben ist. Die Aufgabe wird weiterhin durch ein Spannsystem gelöst, wie es sich aus dem weiteren, nebengeordneten Anspruch ergibt. Bevorzugte Ausführungsformen des Bedienteils ergeben sich aus den Unteransprüchen.

Das Bedienteil zeichnet sich zunächst dadurch aus, dass es kein Außen- und/oder Innengewinde aufweist. Es ist zur Betätigung bzw. zum Arbeiten mit einer Spannmutter vorgesehen, wobei die Spannmutter selbst zum Spannen einer Spannzange eingesetzt werden kann, welche zum Einspannen von Werkzeugschäften in der Werkzeugaufnahme einer Werkzeugmaschine vorgesehen sein kann.

Die Spannmutter selbst weist in der Regel eine Ringform auf und ist mit einem außen- oder innenliegenden Gewinde versehen. Das Gewinde dient im Allgemeinen zum Einschrauben der Spannmutter in eine Aufnahme einer Werkzeugmaschinenspindel oder eines Werkzeugs. Weiterhin kann die Spannmutter in herkömmlicher Weise mit einem Innenkonus zum zentrierten Erfassen einer Spannzange versehen sein.

Das erfindungsgemäße Bedienteil weist einen endständigen, ringförmigen Aufnahmebereich zum Greifen der Spannmutter auf. Der endständige Aufnahmebereich weist hierfür eine Mehrzahl von Nuten auf, die von außen nach innen verlaufen. Zwischen den Nuten sind Nasen ausgebildet. Die von den Nuten begrenzten bzw. von außen nach innen verlaufenden Seitenflanken der Nasen sind jeweils mit einem hinterschnittenen Profil versehen.

Die zu greifende Spannmutter weist in entsprechender Weise auf derjenigen Seite, die dem Bedienteil zugewandt wird, eine Mehrzahl von Nasen mit dazwischenliegenden Nuten auf. Die von außen nach innen verlaufenden Seitenflanken der Nuten sind mit einem Profil versehen, das einen Eingriff der Nasen des Bedienteils in die Nuten und ein Einhaken des Bedienteils erlaubt.

Vorzugsweise handelt es sich bei dem erfindungsgemäßen Bedienteil für die Spannmutter um ein hohlzylindrisches Bedienteil.

Ein wesentlicher Aspekt der Erfindung liegt darin, dass der ringförmige Aufnahmebereich des erfindungsgemäßen Bedienteils einen Zentrierrand aufweist, der die Ebene der Grundfläche der Nuten überragt. Durch diesen Zentrierrand kann im Vergleich mit herkömmlichen Systemen die Stabilität bei der Verbindung zwischen der Spannmutter und dem jeweiligen Bedienteil erheblich verbessert werden. Durch den Zentrierrand wird das Ergreifen der Spannmutter erleichtert und stabilisiert und es kommt nicht zu einem Abrutschen oder Abfallen der Spannmutter von dem Bedienteil.

Der Zentrierrand kann im inneren Bereich des endständigen, ringförmigen Aufnahmebereichs oder im äußeren Bereich des endständigen, ringförmigen Aufnahmebereichs angeordnet sein. In besonders bevorzugten Ausführungsformen ist der Zentrierrand im inneren Bereich des endständigen, ringförmigen Aufnahmebereichs angeordnet.

Vorzugsweise ist das Profil der Seitenflanken der Nasen des Bedienteils derart an das Profil der Nuten bzw. der Nasen der Spannmutter angepasst, dass ein formschlüssiger Eingriff erreicht wird. Vorzugsweise handelt es sich jeweils um komplementäre Profile. Hierdurch kann die Verbindung zwischen dem Bedienteil und der Spannmutter besonders abrutschsicher ausgebildet werden, sodass ein Abfallen der Spannmutter von dem Bedienteil besonders sicher vermieden wird. Weiterhin wird durch den formschlüssigen Eingriff eine besonders effiziente Übertragung des Drehmoments bei dem Spannen oder Lösen der Spannmutter ermöglicht.

Allerdings ist es auch möglich, dass das Profil der Seitenflanken der Nasen des Bedienteils nicht optimal an das Profil der Nuten bzw. der Seitenflanken der Nasen der Spannmutter angepasst ist. Selbst in diesem Fall wird durch den erfindungsgemäß vorgesehenen Zentrierrand erreicht, dass die Spannmutter zuverlässig durch das Bedienteil ergriffen werden kann.

In besonders bevorzugten Ausführungsformen des erfindungsgemäßen Bedienteils ist das hinterschnittene Profil der Seitenflanken der Nasen des Bedienteils ein Rechteckprofil. Mit besonderem Vorteil ist in diesen Ausführungsformen auch die Spannmutter mit einem entsprechendem Rechteckprofil in den Seitenflanken von deren Nasen ausgestattet. Es sind jedoch auch andere hinterschnittene Profile in den Seitenflanken der Nasen des Bedienteils (und der Spannmutter) möglich, beispielsweise S-Profile oder anderes.

In besonders bevorzugten Ausführungsformen sind in dem endständigen, ringförmigen Aufnahmebereich des Bedienteils 3 - 8 Nasen, vorzugsweise sechs Nasen vorgesehen. Vorzugsweise sind die Nasen gleichmäßig über den Umfang des Bedienteils verteilt. Es kann bevorzugt sein, dass die Seitenflanken der Nasen des Bedienteils radial nach innen verlaufen, sodass sich sowohl die Nasen als auch die Nuten nach innen hin verjüngen.

In besonders bevorzugter Weise ist das Bedienteil mindestens zweiteilig aufgebaut. In diesen Ausführungsformen umfasst das erfindungsgemäße Bedienteil
(i) einen Grundkörper, der den endständigen, ringförmigen Aufnahmebereich mit den Nuten und den Nasen umfasst, und
(ii) einen hohlzylindrischen Zentrierring, der den Zentrierrand ausbildet.

Im Fall des Zentrierrands im inneren Bereich erstreckt sich der Zentrierring in das Innere des Grundkörpers. Im Fall des Zentrierrands im äußeren Bereich erstreckt sich der Zentrierring am äußeren Umfang des Grundkörpers.

Diese Ausgestaltung des erfindungsgemäßen Bedienteils erlaubt eine besonders vorteilhafte Fertigung des Bedienteils. Der Grundkörper kann zweckmäßigerweise aus einem gehärteten Material, beispielsweise aus gehärtetem Stahl, gefertigt sein. Eine ausreichende Härte des Materials ist vorteilhaft, da der Grundkörper und insbesondere der ringförmige Aufnahmebereich mit den Nasen bei der Drehmomentübertragung während des Spannens oder Lösens der Spannmutter großen Belastungen ausgesetzt sein kann. Der Zentrierring hingegen ist weniger großen Belastungen ausgesetzt, sodass die Verwendung eines gehärteten Materials für den Zentrierring von untergeordneter Bedeutung ist.

Weiterhin ist es bevorzugt, wenn das Bedienteil und insbesondere der Grundkörper zum Schutz vor Korrosion beschichtet oder anderweitig behandelt ist. Beispielsweise kann eine Verzinkung des Stahls als Material für den Grundkörper vorgesehen sein.

In besonders bevorzugten Ausführungsformen ist der Zentrierring aus Edelstahl gefertigt. Edelstahl ist korrosionsbeständig und langlebig, sodass er sich als Material für den Zentrierring sehr gut eignet. Zudem lässt sich der Zentrierring aus Edelstahl in besonders präziser und passgenauer Weise fertigen. Es kann auch vorgesehen sein, dass das gesamte Bedienteil aus Edelstahl gefertigt ist. Insbesondere auch aus Kostengründen kann es jedoch vorteilhaft sein, den Grundkörper aus gehärtetem Stahl und den Zentrierring aus Edelstahl herzustellen.

In anderen Ausgestaltungen kann der Zentrierring z. B. aus anderem Stahl oder Buntmetall oder Kunststoff gefertigt sein.

In bevorzugten Ausgestaltungen des erfindungsgemäßen Bedienteils kann der Zentrierring in einem Passsitz auf einem inneren, ringförmig sich erstreckenden Absatz des Grundkörpers eingepresst sein. Diese Ausgestaltung erlaubt eine einfache und dabei sehr präzise Fertigung des Bedienteils mit dem innen angeordneten Zentrierrand. In vergleichbarer Weise kann auch für die Anbringung eines äußeren Zentrierrands ein Passsitz verwendet werden.

Es ist jedoch auch möglich, dass das erfindungsgemäße Bedienteil als einteiliges Stück gefertigt wird, bei dem also der Zentrierrand in den Grundkörper unmittelbar integriert wird.

Der Grundkörper des erfindungsgemäßen Bedienteils, mit oder ohne integriertem Zentrierrand, kann beispielsweise als Gussteil, insbesondere als Feingussteil gefertigt werden. Die Strukturen des Grundkörpers im Bereich der Nasen und Nuten des Aufnahmebereichs können beispielsweise durch Wachsausschmelz- oder Druckgussverfahren oder, bevorzugt, durch computergestütze Zerspanverfahren beispielsweise auf CNC-Maschinen hergestellt werden. Weiterhin ist es beispielsweise möglich, das Bedienteil mit oder ohne integrierten Zentrierring durch 3D-Druck herzustellen.

In ganz besonders bevorzugten Ausführungsformen des erfindungsgemäßen Bedienteils zeichnet sich das Bedienteil dadurch aus, dass sich der äußere Abschluss des Zentrierrandes unterhalb der Ebene der Außenflächen der Nasen, also der Außenflächen der Nasen in axialer Richtung, befindet. Das heißt, dass die Nasen etwas länger als die Höhe des Zentrierrandes sind. Dieser Ausgestaltung des Bedienteils liegt zugrunde, dass eine Spannzange üblicherweise eine gewisse Untermaßspannung aufweist. Durch die verringerte Höhe des Zentrierrandes und den damit bewirkten Freiraum wird vermieden, dass die Vorderseite der Spannzange beim Anziehen der Spannmutter direkt an das Bedienteil anschlagen kann und damit blockiert wird.

In Abhängigkeit von den Dimensionen des Spannsystems kann der äußere Abschluss des Zentrierrandes im Verhältnis zur Ebene der Außenflächen der Nasen beispielsweise zwischen 0,5 - 1,0 mm zurückversetzt sein. Bei einem handelsüblichen Spannsystem kann der Zentrierrand des Bedienteils vorzugsweise um 0,4 - 0,6 mm, besonders bevorzugt 0,5 mm, kürzer als die Höhe der Nasen sein.

In besonders bevorzugten Ausführungsformen des erfindungsgemäßen Bedienteils ist dasjenige Ende des Bedienteils, das dem Aufnahmebereich mit den Nasen entgegensetzt liegt, mit einem Außensechskant oder -vierkant oder beispielsweise einem Innenvierkant versehen. Der Bereich mit dem Außensechs- oder vierkant oder dem Innenvierkant dient insbesondere als Angriffsbereich für ein Bedienwerkzeug, beispielsweise für einen Drehmomentschlüssel.

In besonders bevorzugten Ausführungsformen ist das erfindungsgemäße Bedienteil als Stecknuss ausgebildet, wobei zwischen dem Aufnahmebereich mit den Nasen und dem Zentrierrand auf der einen Seite und dem Bereich für den Angriff eines Bedienwerkzeugs auf der anderen Seite ein mehr oder weniger langer Schaft vorgesehen ist. Die Länge der Stecknuss bzw. die Länge des Schafts ist vorzugsweise an die jeweilige Verwendung der Stecknuss angepasst. Insbesondere hängt die Länge der Stecknuss von der Länge des Werkzeugschafts ab, der mit Hilfe des Bedienteils in eine Spannzange eingespannt werden soll.

Je nach Länge der Stecknuss kann es vorteilhaft sein, wenn die Stecknuss mit gewichtsreduzierenden Merkmalen ausgebildet ist. Insbesondere können drei, vier oder mehr Langlöcher in dem Schaft der Stecknuss vorgesehen sein. Neben der hiermit verbundenen Gewichtsreduzierung haben die Langlöcher auch den Vorteil, dass der innerhalb der Stecknuss verlaufende Werkzeugschaft während des Spannvorgangs für den Bediener sichtbar ist.

Als weitere gewichtsreduzierende Maßnahme können ein oder mehrere Ausfräsungen insbesondere am Schaft des Bedienteils, beispielsweise als umlaufender Verjüngungsring, vorgenommen werden, die die Wandstärke und damit das Gewicht der Stecknuss reduzieren.

In besonders bevorzugten Ausführungsformen ist die Stecknuss als Drehmomentstecknuss ausgebildet. In dieser Ausführungsform ist die Stecknuss dazu vorgesehen, die Verbindung mit einem Drehmomentschlüssel herzustellen. Durch die Vermeidung eines Abrutschens der Drehmomentstecknuss von der Spannmutter infolge des erfindungsgemäß vorgesehenen Zentrierrandes ist ein besonders sicheres Arbeiten mit der Drehmomentstecknuss möglich. Zudem gewährleistet die Drehmomentstecknuss einen gewissen Abstand der Bedienperson zu gegebenenfalls scharfkantigen Werkzeugen der Werkzeugmaschine und verringert somit auch aus diesem Grund das Verletzungsrisiko für die Bedienperson.

In weiteren bevorzugten Ausführungsformen ist die Stecknuss als eine mehrteilige Stecknuss ausgebildet, insbesondere als modulare Stecknuss. Die mehrteilige Stecknuss umfasst einen Grundhalter und ein wechselbares Teil (Bedienelement), wobei das wechselbare Teil den endständigen, ringförmigen Aufnahmebereich und den Zentrierrand gemäß der obigen Beschreibung umfasst.

Vorzugsweise ist das wechselbare Teil (Bedienelement) mit dem Grundhalter mittels einer Überwurfgewindeverbindung, insbesondere mittels einer Nocken-Überwurfgewindeverbindung, verbunden. Die Nocken-Überwurfgewindeverbindung erlaubt eine besonders stabile Verbindung der beiden Elemente.

Das wechselbare Teil (Bedienelement) mit dem endständigen, ringförmigen Aufnahmebereich und dem Zentrierrand unterliegt einem gewissen Verschleiß. In dieser Ausführungsform in Form einer mehrteiligen Stecknuss ist es möglich, dass bei Bedarf nur das wechselbare Teil, also das Verschleißteil, ausgetauscht wird. Dies hat für den Anwender den Vorteil, dass nicht die komplette Stecknuss ausgetauscht werden muss. Diese Ausführungsform stellt daher für den Anwender eine sehr kostengünstige Lösung dar.

Weiterhin kann der Grundhalter so ausgelegt werden, dass mit zwei oder drei Grundhaltergrößen zusammen mit gegebenenfalls mehreren verschiedenen wechselbaren Teilen (Bedienelementen) die gesamte Palette von Spannmuttern unterschiedlicher Größe bedient werden kann.

In anderen Ausführungsformen des Bedienteils handelt es sich bei dem Bedienteil um eine Eindrehhilfe. Die Eindrehhilfe unterscheidet sich von der Stecknuss insbesondere dadurch, dass die Eindrehhilfe keinen ausgeprägten Schaft aufweist und damit im Allgemeinen kürzer als eine Stecknuss ist. Unter Verwendung der Eindrehhilfe kann das Aufsetzen der Spannmutter auf die Spannzange erheblich erleichtert werden, da oftmals der Raum zum Hantieren im Bereich der Spannzange eng ist und mit den Händen nur schwer zu erreichen ist. Nach dem Eindrehen der Spannmutter mit Hilfe der Eindrehhilfe kann zu der Drehmomentstecknuss gewechselt werden, sodass die Spannmutter effektiv und verletzungsfrei angezogen werden kann.

Als weitere Ausführungsformen des erfindungsgemäßen Bedienteils können beispielsweise Verlängerungen oder Steckhülsen entsprechend mit dem oben beschriebenen Aufnahmebereich mit Nuten, Nasen und einem Zentrierrand ausgebildet sein.

Die Erfindung umfasst weiterhin ein Spannsystem zum Arbeiten mit einer Spannzange bzw. zum Einspannen von Werkzeugschäften mittels einer Spannzange. Das System umfasst mindestens eine Spannmutter und mindestens ein Bedienteil gemäß der obigen Beschreibung. Das Bedienteil ist vorzugsweise als Stecknuss oder als Eindrehhilfe ausgebildet. Vorzugsweise umfasst das System sowohl mindestens eine Stecknuss als auch mindestens eine Eindrehhilfe. Vorzugsweise sind mehrere Stecknüsse unterschiedlicher Länge in dem System enthalten.

Weiterhin kann das System gegebenenfalls einen oder mehrere herkömmliche Schlüssel enthalten, die mit entsprechenden Nasen bzw. Vorsprünge auf einem teilkreisförmigen Schlüsselkopf zum Eingriff in die entsprechenden Strukturen der Spannmutter versehen sind. Mit einem solchen Schlüssel kann die Spannmutter bei Bedarf per Hand gespannt oder gelöst werden.

Weitere Merkmale und Vorteile der Erfindung ergeben sich aus der nachfolgenden Beschreibung von Ausführungsbeispielen in Verbindung mit den Zeichnungen. Hierbei können die einzelnen Merkmale jeweils für sich oder in Kombination miteinander verwirklicht sein.

### Kurze Beschreibung der Zeichnungen

In den Zeichnungen zeigt:
- Fig. 1: Schrägansicht eines Spannsystems mit Spannzange, Spannmutter und erfindungsgemäßem Bedienteil;
- Fig. 2: erfindungsgemäßes Bedienteil in einer Ausführungsform als Eindrehhilfe mit einem innen angeordneten Zentrierrand - Schrägansicht von unten (A), Längsschnitt (B), Aufsicht von unten (C);
- Fig. 3: Spannmutter - Schrägansicht von oben (A), Längsschnitt (B), Aufsicht von oben (C);
- Fig. 4: erfindungsgemäßes Bedienteil in einer Ausführungsform als Stecknuss - Schrägansicht von unten (A), Längsschnitt (B), Aufsicht von unten (C), Aufsicht von oben (D);
- Fig. 5: erfindungsgemäßes Bedienteil in einer Ausführungsform als Eindrehhilfe in verschiedenen Ausgestaltungen A - D, jeweils in Längsschnitt (rechts) und in Aufsicht von unten (links);
- Fig. 6: verschiedene hinterschnittene Profilformen der Nasen (A - I) des erfindungsgemäßen Bedienteils;
- Fig. 7: Schlüssel in Aufsicht von unten (A) und im Längsschnitt (B);
- Fig. 8: erfindungsgemäßes Bedienteil in einer Ausführungsform als modulare Stecknuss mit einem Grundhalter und einem wechselbaren Teil in einer Schrägansicht der beiden Teile in zusammengesetzter Form (A) und in getrennter Form (B) sowie als Schnittansicht des wechselbaren Teils in isolierter Form (C); und
- Fig. 9: erfindungsgemäßes Bedienteil in einer Ausführungsform als Eindrehhilfe mit einem außen angeordneten Zentrierrand - Schrägansicht von unten (A), Längsschnitt (B), Aufsicht von unten (C).

### Ausführungsbeispiele der Erfindung

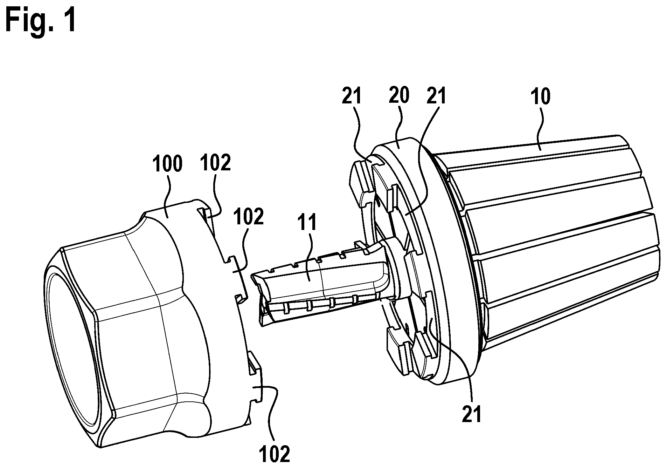

**Fig. 1** zeigt ein Spannsystem mit einer Spannzange 10 zum Einspannen eines Werkzeugschaftes 11, einer Spannmutter 20 und einem erfindungsgemäßen Bedienteil 100. Das Bedienteil 100 ist in Form einer Eindrehhilfe ausgebildet. Auf der der Spannmutter 20 zugewandten Seite ist das Bedienteil 100 mit einer Mehrzahl von Nasen 102 versehen. Die Nasen 102 weisen auf ihren von außen nach innen verlaufenden Seitenflanken jeweils ein hinterschnittenes Profil auf. Die Nasen 102 des Bedienteils 100 sind zum formschlüssigen Eingriff in entsprechende Nuten 21 der Spannmutter 20 vorgesehen, sodass das Bedienteil 100 in die Spannmutter 20 eingreifen kann und eine effiziente Drehmomentübertragung möglich ist.

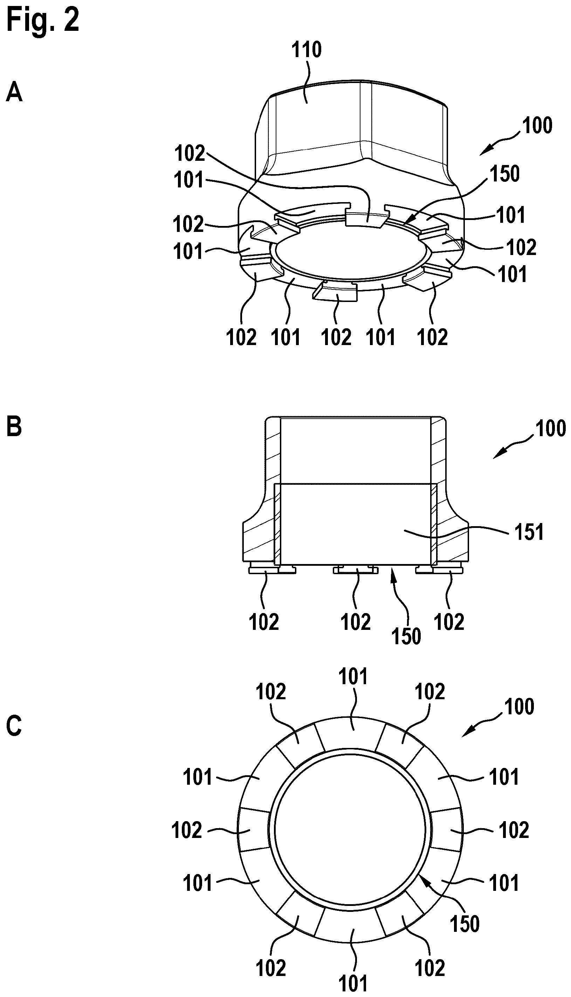

Aus **Fig. 2** gehen weitere Details des erfindungsgemäßen Bedienteils 100 hervor. Die in Teilfigur A gezeigte Schrägansicht von unten lässt die sechs Nasen 102 in dem unteren ringförmigen Aufnahmebereich des Bedienteils 100 erkennen. Zwischen den Nasen 102 erstrecken sich sechs Nuten 101. Die jeweiligen, von außen nach innen verlaufenden Seitenflanken der Nasen 102 weisen ein hinterschnittenes Profil, in diesem Fall ein Rechteckprofil, auf.

Auf der dem Aufnahmebereich entgegengesetzten Seite des Bedienteils 100 ist ein Außensechskant 110 ausgebildet. Über den Außensechskant 110 kann das Bedienteil 100 mit einem entsprechenden Schlüssel betätigt werden. Alternativ kann das Bedienteil 100, insbesondere in dieser Ausgestaltung als Eindrehhilfe, in dem Bereich des Außensechskants 110 auch von Hand gegriffen werden.

Als ein wesentliches Merkmal der Erfindung ist das Bedienteil 100 mit einem inneren Zentrierrand 150 ausgestattet. Der Zentrierrand 150 überragt die Ebene der Grundfläche der Nuten 101. Der Zentrierrand 150 verhindert ein seitliches Abrutschen und/oder Verkanten des Bedienteils 100 beim Aufsetzen und bei dem Ergreifen der Spannmutter. Durch den Zentrierrand 150 wird daher das Ansetzen und die Verbindung des Bedienteils 100 mit der Spannmutter wesentlich vereinfacht und stabilisiert. Im Vergleich mit herkömmlichen Spannsystemen kann die Handhabung des Systems durch das erfindungsgemäße Bedienteil 100 verbessert und das Verletzungsrisiko für die Bedienperson gesenkt werden.

Die Teilfigur B der Fig. 2 zeigt einen Längsschnitt durch das Bedienteil 100. Zu erkennen ist die zweiteilige Ausführung mit dem im Inneren des hohlzylindrischen Bedienteils 100 durch Passsitz eingepressten Zentrierring 151. Der eingepresste Zentrierring 151 bildet den Zentrierrand 150 aus. Der Zentrierrand 150 überragt die Ebene der Grundfläche der Nuten 101. Die Höhe des Zentrierrandes 150 ist etwas niedriger als die Höhe der Nasen 102.

Die Teilfigur C der Fig. 2 zeigt eine Aufsicht auf die Unterseite des Bedienteils 100 mit den Nasen 102, den dazwischenliegenden Nuten 101 sowie dem innenliegenden Zentrierrand 150.

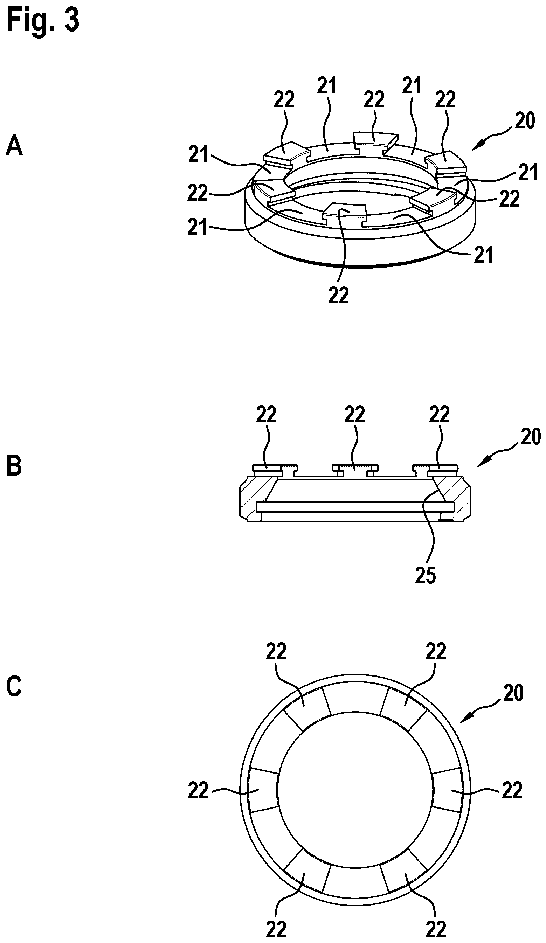

Zur Veranschaulichung des Spannsystems insgesamt zeigt die **Fig. 3** eine Spannmutter 20. Die Teilfigur A zeigt eine Schrägansicht von oben. Die ringförmige Spannmutter 20 ist in der Regel mit einem hier nicht dargestellten Außengewinde oder mit einem Innengewinde versehen. Auf ihrer Oberseite ist die Spannmutter 20 mit einer Mehrzahl von Nasen 22 und dazwischen liegenden Nuten 21 versehen. Die Nasen 22 zeigen an ihren jeweiligen Seitenflanken ein hinterschnittenes Profil. In diesem Ausführungsbeispiel ist ein hinterschnittenes Rechteckprofil an den Seitenflanken der Nasen 22 bzw. an den Seitenflanken der Nuten 21 ausgebildet.

In der Teilfigur B der Fig. 3 ist der im Inneren der Spannmutter 20 ausgebildete konische Bereich 25 zu erkennen, der zum passgenauen Einsetzen einer Spannzange vorgesehen ist. Die Aufsicht von oben in der Teifigur C der Fig. 3 zeigt die Anordnung der Nasen 22, die gleichmäßig über den Umfang der ringförmigen Spannmutter 20 verteilt sind.

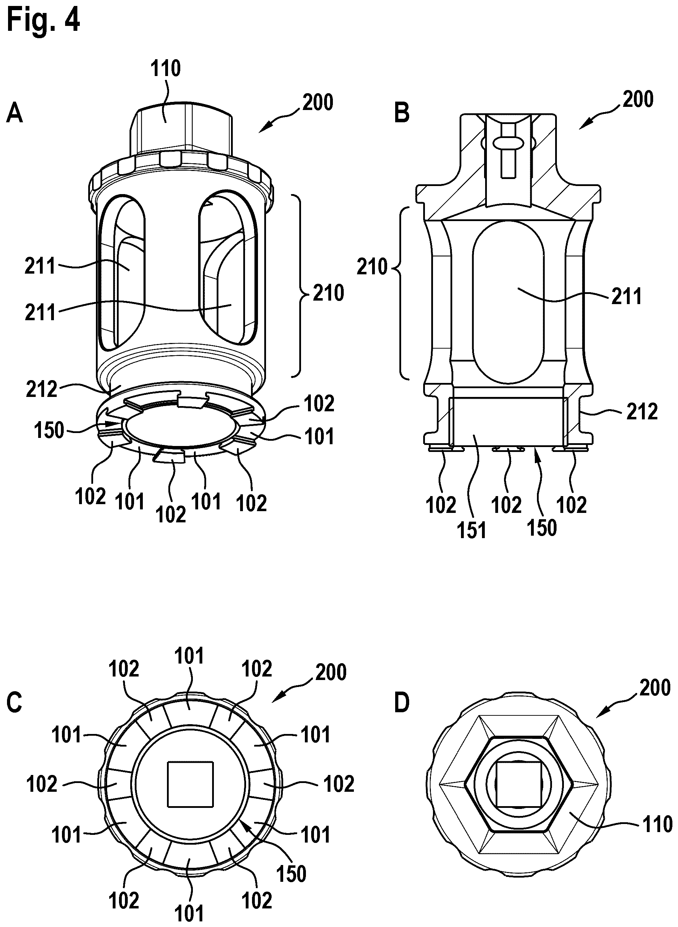

**Fig. 4** zeigt das erfindungsgemäße Bedienteil 200 in einer weiteren, besonders bevorzugte Ausführungsform als Stecknuss. Teilfigur A zeigt eine Schrägansicht von unten und Teilfigur B einen Längsschnitt. Der untere Aufnahmebereich mit den Nasen 102 und den dazwischenliegenden Nuten 101 sowie dem inneren Zentrierrand 150 und dem Zentrierring 151 entspricht dem in Fig. 2 gezeigten Aufnahmebereich des dort gezeigten Bedienteils 100 in Form einer Eindrehhilfe.

Auch in dieser Ausführungsform des Bedienteils 200 als Stecknuss verhindert der Zentrierrand 150 ein Abrutschen einer Spannmutter von der Stecknuss. Der Zentrierrand 150 erleichtert daher die Handhabung des Systems und verringert das Verletzungsrisiko.

Auch bei dem in Fig. 4 gezeigten Bedienteil 200 in Form einer Stecknuss ist im oberen Bereich des Bedienteils ein Außensechskant 110 ausgebildet. In diesem Fall dient der Außensechskant 110 insbesondere zur Verbindung mit einem Drehmomentschlüssel zum Spannen und Lösen einer Spannmutter.

Zwischen dem Bereich mit dem Außensechskant 110 und dem Aufnahmebereich mit den Nasen 102 weist das Bedienteil 200 einen Schaft 210 auf. Der Schaft 210 weist mehrere Langlöcher 211 auf (vier Langlöcher), die eine Sicht für die Bedienperson auf den im Inneren der Stecknuss beim Spannen der Spannzange befindlichen Werkzeugschaft erlauben.

Weiterhin wird durch die Langlöcher 211 eine Materialreduzierung erreicht, die das Gewicht des Bedienteils 200 verringert.

Als weitere Maßnahme insbesondere zur Gewichtsreduzierung ist in dieser Ausführungsform eine umlaufenden Verjüngung 212 vorgesehen, die mit einer Reduzierung der Wandstärke des hohlzylindrischen Bedienteils 200 verbunden ist.

Die Teilfigur C der Fig. 4 zeigt eine Aufsicht von unten, bei der die Nasen 102, die dazwischenliegenden Nuten 101 sowie der Zentrierrand 150 zu erkennen ist. Die Teilfigur D der Fig. 4 zeigt eine Aufsicht auf das Bedienteil von oben auf den Bereich mit dem Außensechskant 110.

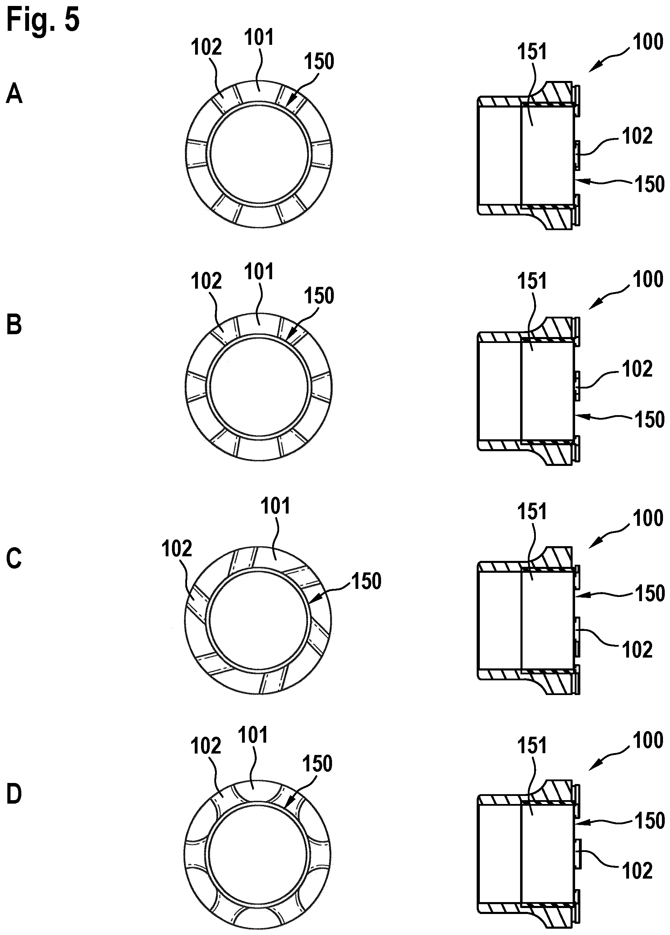

Die Teilfiguren A - D der **Fig. 5** zeigen verschiedene beispielhafte Ausgestaltungen der Nasen 102 und der dazwischenliegenden Nuten 101 bei dem erfindungsgemäßen Bedienteil 100. Bei der hier gezeigten Ausführungsform des Bedienteils handelt es sich um eine Eindrehhilfe. In entsprechender Weise kann das Bedienteil als Stecknuss, insbesondere als Drehmomentstecknuss wie in Fig. 4, ausgebildet sein. Jeweils rechts ist eine Schnittdarstellung gezeigt, die den im Inneren des Bedienteils 100 eingepressten Zentrierring 151 zeigt. Der auf der Seite der Nasen 102 über die Ebene der Grundfläche der Nuten 101 herausragende Rand des Zentrierrings 151 bildet den Zentrierrand 150.

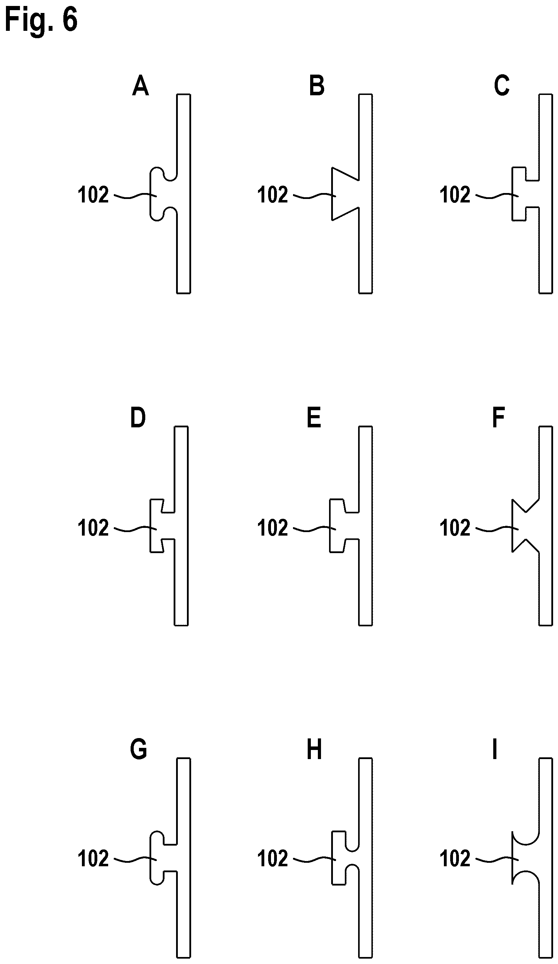

Die Teilfiguren A - I der **Fig. 6** zeigen verschiedene mögliche Hinterschnittprofile in den Seitenflanken der Nasen 102 des erfindungsgemäßen Bedienteils 100, 200. Das jeweilige Hinterschnittprofil erstreckt sich senkrecht zur radialen Ausrichtung der Seitenflanken der Nasen 102.

Beispielsweise zeigt die Teilfigur C der Fig. 6 das besonders bevorzugte Rechteckprofil. Die Teilfigur B der Fig. 6 zeigt das aus dem Stand der Technik bekannte schwalbenschwanzförmige Profil und die Teilfigur A der Fig. 6 zeigt das aus dem Stand der Technik bekannte S-Profil.

Auch die Nasen der jeweiligen Spannmutter sind vorzugsweise mit dem entsprechenden Profil versehen, um einen optimalen Formschluss zu erreichen. Es können unter Umständen jedoch auch gewisse Abweichungen der jeweiligen Profile tolerierbar sein.

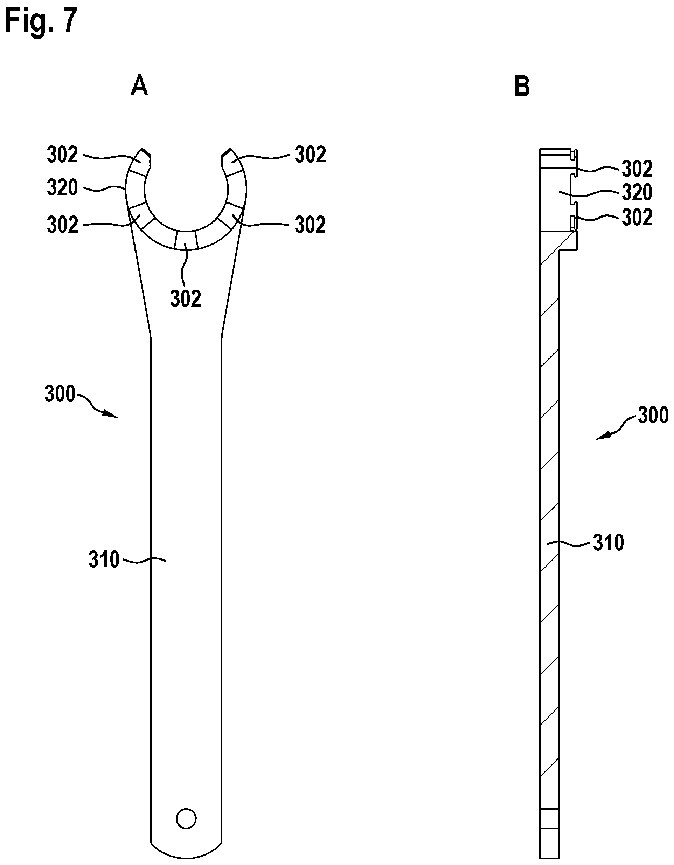

**Fig. 7** zeigt in einer Ansicht von unten (Teilfigur A) und in einer Längsschnittansicht (Teilfigur B) einen Schlüssel 300, mit dem eine Spannmutter des Spannsystems per Hand gelöst oder angezogen werden kann. Der Schlüssel weist einen Griff 310 sowie einen Schlüsselkopf 320 auf. Der Schlüsselkopf 320 wird von einem teilkreisförmigen Kragen gebildet, auf dem sich mehrere Nasen 302 als Vorsprünge befinden. In diesem Ausführungsbeispiel sind es fünf Nasen, die gleichmäßig über den Umfang des teilkreisförmigen Kragens verteilt sind. Die Nasen 302 sind vorzugsweise mit einem entsprechenden hinterschnittenen Profil wie die Nasen der jeweiligen Spannmutter und/oder wie die Nasen des jeweiligen erfindungsgemäßen Bedienteils ausgebildet.

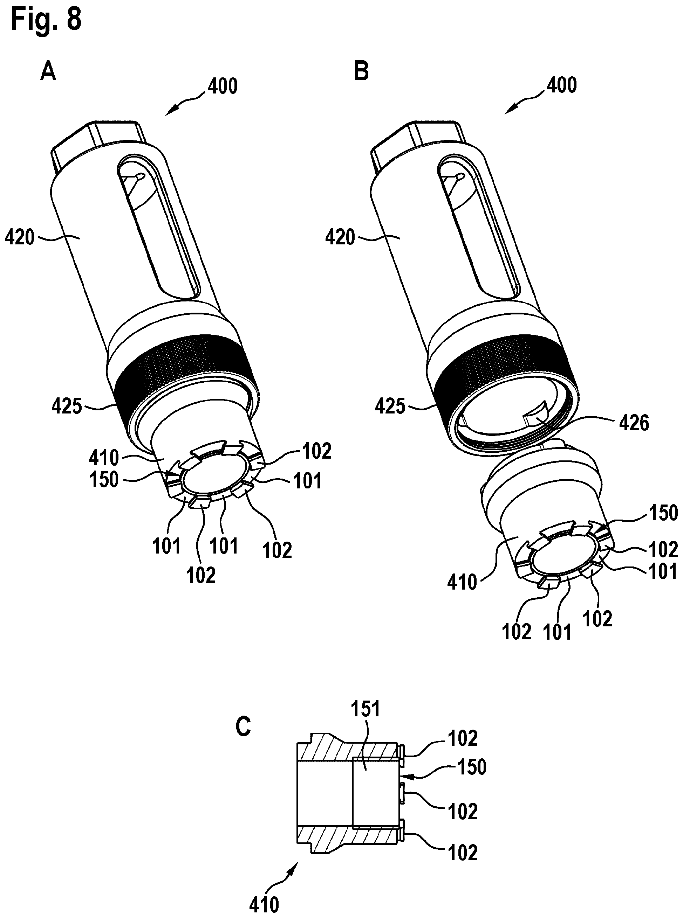

**Fig. 8** zeigt eine mehrteilige (modulare) Stecknuss 400, die von einem Grundhalter 420 und einem wechselbaren Teil (Bedienelement) 410 gebildet wird. Das wechselbare Teil 410 umfasst einen endständigen, ringförmigen Aufnahmebereich mit einer Mehrzahl von Nasen 102 und dazwischen liegenden Nuten 101 sowie einem innen liegenden Zentrierrand 150 gemäß der obigen Beschreibung. Die Funktion der modularen Stecknuss 400 ist mit der Stecknuss 200, die anhand der Fig. 4 erläutert wurde, vergleichbar. Die entsprechenden Elemente der modularen Stecknuss 400 sind mit den gleichen Bezugszeichen versehen.

Der Vorteil der modularen Stecknuss 400 liegt vor allem darin, dass das wechselbare Teil 410 z. B. bei einem eingetretenen Verschleiß ausgetauscht werden kann, ohne dass die komplette Stecknuss ausgetauscht werden müsste. Weiterhin kann die modulare Stecknuss 400 so ausgebildet sein, dass verschiedene Größen von Spannmuttern durch entsprechende Größen des wechselbaren Teils 410 bedient werden können. Darüber hinaus können verschiedene Größen des Grundhalters 420 bereitgestellt werden, sodass mit einem solchen modularen System in kostengünstiger Weise alle Erfordernisse abgedeckt werden können.

Das wechselbare Teil 410 ist mit dem Grundhalter 420 über eine Nocken-Überwurfgewindeverbindung 425 verbunden. Teilfigur A zeigt die mehrteilige Stecknuss 400 in zusammengesetzter Form. Teilfigur B zeigt den Grundhalter 420 und das wechselbare Teil 410 in getrennter Form, wobei die Nocke 426 für die Nocken-Überwurfgewindeverbindung 425 sichtbar ist.

Die Teilfigur C der Fig. 8 zeigt eine Schnittansicht des wechselbaren Teils (Bedienelement) 410. Anhand dieser Darstellung ist der im Inneren des Teils 410 angeordnete Zentrierring 151 erkennbar. Der Zentrierring 151 bildet den Zentrierrand 150.

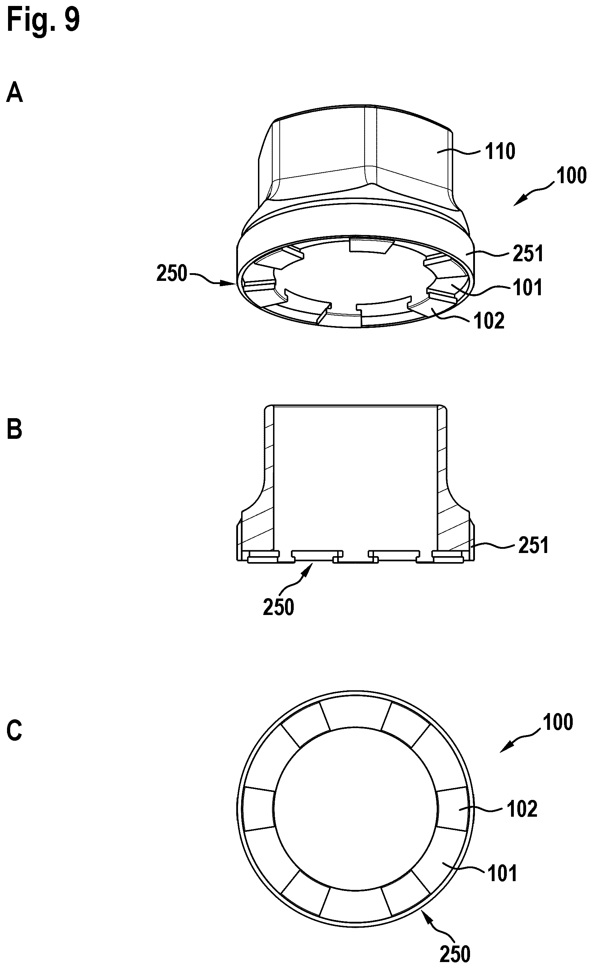

**Fig. 9** zeigt in vergleichbarer Weise wie Fig. 2 eine Ausführungsform des Bedienteils 100 als Eindrehhilfe. Im Unterschied zu der Ausführungsform der Fig. 2 mit einem inneren Zentrierrand weist die Ausführungsform der Fig. 9 einen äußeren Zentrierrand 250 auf. Der äußere Zentrierrand 250 wird in dieser Ausführungsform von einem außen angebrachten, hohlzylindrischen Zentrierring 251 gebildet. Im Übrigen entspricht die in Fig. 9 gezeigte Eindrehhilfe der Eindrehhilfe der Fig. 2 und es wird auf die Ausführungen zu Fig. 2 Bezug genommen. Ein außen sitzender Zentrierrand 250 kann auch bei den anderen, oben erläuterten Ausführungsformen alternativ zu einem innen sitzenden Zentrierrand verwendet werden.

## Patentansprüche

1. Bedienteil (100; 200; 400) zur Betätigung einer Spannmutter (20), wobei das Bedienteil (100; 200; 400) einen endständigen, ringförmigen Aufnahmebereich zum Greifen der Spannmutter (20) aufweist und wobei der endständige, ringförmige Aufnahmebereich eine Mehrzahl von Nuten (101), die von außen nach innen verlaufen, und zwischen den Nuten liegenden Nasen (102) umfasst, wobei die von den Nuten (101) begrenzten Seitenflanken der Nasen (102) jeweils mit einem hinterschnittenen Profil versehen sind, **dadurch gekennzeichnet, dass** der endständige, ringförmige Aufnahmebereich einen Zentrierrand (150; 250) aufweist, der die Ebene der Grundfläche der Nuten (101) überragt.

2. Bedienteil nach Anspruch 1, **dadurch gekennzeichnet, dass** der Zentrierrand (150) im inneren Bereich des endständigen, ringförmigen Aufnahmebereichs angeordnet ist.

3. Bedienteil nach Anspruch 1, **dadurch gekennzeichnet, dass** der Zentrierrand (250) im äußeren Bereich des endständigen, ringförmigen Aufnahmebereichs angeordnet ist.

4. Bedienteil nach einem der Ansprüche 1 bis 3, **dadurch gekennzeichnet, dass** das hinterschnittene Profil der Seitenflanken der Nasen (102) ein Rechteckprofil ist.

5. Bedienteil nach einem der vorhergehenden Ansprüche, **dadurch gekennzeichnet, dass** das Bedienteil (100; 200; 400) mindestens zweiteilig aufgebaut ist und
(i) einen Grundkörper umfasst, der den endständigen, ringförmigen Aufnahmebereich mit den Nuten (101) und den Nasen (102) aufweist, und
(ii) einen hohlzylindrischen Zentrierring (151; 251) umfasst, der den Zentrierrand (150; 250) ausbildet und der sich in das Innere des Grundkörpers erstreckt oder sich am äußeren Umfang des Grundkörpers erstreckt.

6. Bedienteil nach Anspruch 5, **dadurch gekennzeichnet, dass** der Zentrierring (151; 251) aus Edelstahl gefertigt ist.

7. Bedienteil nach Anspruch 5 oder Anspruch 6, **dadurch gekennzeichnet, dass** der Zentrierring (151) in einem Passsitz auf einem inneren, ringförmig sich erstreckenden Absatz des Grundkörpers eingepresst ist.

8. Bedienteil nach einem der vorhergehenden Ansprüche, **dadurch gekennzeichnet, dass** sich der äußere Abschluss des Zentrierrandes (150; 250) unterhalb der Ebene der Außenflächen der Nasen (102) befindet.

9. Bedienteil nach einem der vorhergehenden Ansprüche, **dadurch gekennzeichnet, dass** das dem Aufnahmebereich entgegengesetzte Ende des Bedienteils mit einem Außensechskant (110) oder einem Innenvierkant versehen ist.

10. Bedienteil nach einem der vorhergehenden Ansprüche, **dadurch gekennzeichnet, dass** das Bedienteil (200; 400) eine Stecknuss ist.

11. Bedienteil nach Anspruch 10, **dadurch gekennzeichnet, dass** die Stecknuss eine Drehmomentstecknuss ist.

12. Bedienteil nach Anspruch 10 oder Anspruch 11, **dadurch gekennzeichnet, dass** die Stecknuss eine mehrteilige Stecknuss (400) ist, die einen Grundhalter (420) und ein wechselbares Teil (410) mit dem endständigen, ringförmigen Aufnahmebereich und dem Zentrierrand (150; 250) gemäß einem der Ansprüche 1 bis 9 umfasst.

13. Bedienteil nach Anspruch 12, **dadurch gekennzeichnet, dass** das wechselbare Teil (410) mit dem Grundhalter (420) mittels einer Überwurfgewindeverbindung (425) verbunden ist.

14. Bedienteil nach einem der Ansprüche 1 bis 9, **dadurch gekennzeichnet, dass** das Bedienteil (100) eine Eindrehhilfe ist.

15. Spannsystem zum Arbeiten mit einer Spannzange (10), umfassend mindestens eine Spannmutter (20) und mindestens ein Bedienteil (100; 200, 400) gemäß einem der Ansprüche 1 bis 14, insbesondere mindestens eine Eindrehhilfe und/oder mindestens eine Stecknuss, sowie gegebenenfalls mindestens einen Schlüssel (300) zum händischen Betätigen der Spannmutter.
